# EUROPEAN PATENT SPECIFICATION

(11) **EP 3 761 466 B1**
(45) Date of publication and mention of the grant of the patent: **18.03.2026**
(21) Application number: 18931254.9
(22) Date of filing: 21.08.2018
(51) Int. Cl.: H02G 1/00, H04B 3/44, G01R 31/08, G01R 31/12

(54) **CABLE ASSIST DEVICE, AND SUBMARINE CABLE ASSIST SYSTEM**
KABELUNTERSTÜTZUNGSVORRICHTUNG UND UNTERWASSERKABELUNTERSTÜTZUNGSSYSTEM
DISPOSITIF D'ASSISTANCE DE CÂBLE ET SYSTÈME D'ASSISTANCE DE CÂBLE SOUS-MARIN

(43) Date of publication of application: 06.01.2021
(73) Proprietor: HMN TECHNOLOGIES CO., LIMITED, Tianjin 300467 (CN)
(72) Inventor: XU, Fei, Tianjin 300457 (CN); XU, Changwu, Tianjin 300457 (CN); SHI, Liyuan, Tianjin 300457 (CN); MA, Liping, Tianjin 300457 (CN)
(74) Representative: Cabinet Beau de Loménie
(86) International application number: PCT/CN2018/101481
(87) International publication number: WO 2020/037488

(56) References cited:
- CN-A- 103 701 493
- CN-A- 104 062 526
- CN-A- 104 965 160
- CN-U- 203 350 393
- JP-A- 2014 240 810
- US-A1- 2003 151 521

## Description

### FIELD OF THE INVENTION

This application relates to the field of cables, and in particular, to a cable accessory device and a submarine cable accessory system.

### BACKGROUND OF THE INVENTION

A cable is a conducting wire configured to transmit power or signals. At present, common cables include electric cables, optical cables, and the like. The electric cable is a conductor structure wrapped with an insulating material, and may be configured to transmit power or signals. During specific implementations, connectivity of the conductor structure may be represented by using direct current resistance of the conductor structure in the electric cable, and smaller direct current resistance of the conductor structure indicates better connectivity of the conductor structure. The optical cable is a light-guide fiber wrapped with a protection tube, and may be configured to transmit optical signals. In the optical cable, a conductor structure may further be disposed at the same time. Safety of the optical cable is monitored by testing resistance connectivity of the conductor structure. During specific implementations, connectivity of the conductor structure in the optical cable may be represented by using direct current resistance of the conductor structure. For example, if the direct current resistance of the conductor structure remarkably changes during a test process, it indicates that the conductor structure in the optical cable may be damaged or fractured, and the light-guide fiber in the optical cable may also be damaged or fractured at the same time.

Meanwhile, an insulation structure that is in the cable and is configured to wrap the conductor structure may be made of a one-layer insulating material, or may be made of a multi-layer insulating material. The insulation structure may protect the conductor structure, and insulate the conductor structure in the cable from other conductors, to avoid electric leakage when the conductor structure is powered on. Insulation resistance of the insulation structure in the cable is an indicator for reflecting performance of the insulation structure, and greater insulation resistance of the insulation structure indicates better performance of the insulation structure.

Document US 2003/151521 dicloses a known cable accessory device.

Document CN 103 701 493 also discloses a known cable accessory device.

At present, quality of the cable may be reflected by using the direct current resistance of the conductor structure in the cable and the insulation resistance of the insulation structure in the cable. However, in a current test system, in some application scenarios, only one of the direct current resistance of the conductor structure and the insulation resistance of the insulation structure may be tested due to technological constraints. Therefore, failures of the cable cannot be comprehensively investigated. As a result, damages to the cable cannot be found in time, thus having a problem that subsequent costs in locating and maintenance are added.

### SUMMARY OF THE INVENTION

The present invention is defined by the attached independent claims. Other preferred embodiments may be found in the dependent claims. The present application discloses a cable accessory device, wherein the device comprises: a one-way conducting element (301) and a grounding electrode (102), one end of the one-way conducting element being connected to a conductor structure in the cable, and the other end of the one-way conducting element being connected to the grounding electrode; the conductor structure in the cable is configured to enable, when being applied with voltages with different polarities, the one-way conducting element to have different on/off states; and the one-way conducting element is configured to connect the conductor structure in the cable to the grounding electrode when the on/off state is an on state, and to break connection between the conductor structure and the grounding electrode when the on/off state is an off state, characterized in that a positive electrode of the one-way conducting element is connected to the conductor structure, and a negative electrode is connected to the grounding electrode; and wherein the conductor structure in the cable being configured to enable, when being applied with voltage with different polarities, the one-way conducting element to have different on/off states, comprises:enabling the one-way conducting element to be in the off state when the conductor structure is applied with negative voltage; and enabling the one-way conducting element to be in the on state when the conductor structure is applied with positive voltage.The present application discloses a submarine cable accessory system, comprising a submarine cable accessory device (100), a power feeding equipment (200), and a repeater (104), wherein the repeater is connected between the submarine cable (103) accessory device and the power feeding equipment via a submarine cable, wherein the submarine cable accessory device comprises: a one-way conducting element (100) and a grounding electrode, one end of the one-way conducting element being connected to a conductor structure in the submarine cable, and the other end of the one-way conducting element being connected to the grounding electrode; the conductor structure in the submarine cable is configured to enable, when being applied with voltages with different polarities by the power feeding equipment, the one-way conducting element to have different on/off states; the one-way conducting element is configured to connect the conductor structure in the submarine cable to the grounding electrode when the on/off state is an on state, and to break connection between the conductor structure and the grounding electrode when the on/off state is an off state; and the repeater is configured to connect multiple sections of the submarine cable between the submarine cable accessory device and the power feeding equipment, and amplify a signal in the submarine cable.

### BRIEF DESCRIPTION OF THE DRAWINGS

FIG. 1 is a schematic structural diagram of a submarine cable according to an embodiment of this application;
FIG. 2 is a schematic diagram of a method for testing direct current resistance of a conductor structure according to an embodiment of this application;
FIG. 3 is a schematic diagram of a method for testing insulation resistance of an insulation structure according to an embodiment of this application;
FIG. 4 is a schematic diagram of a looped fibre end seal in the prior art;
FIG. 5 is a schematic diagram of a method for testing direct current resistance of a conductor structure in a submarine cable in the prior art;
FIG. 6 is a schematic diagram of a method for testing insulation resistance of an insulation structure in a submarine cable in the prior art;
FIG. 7 shows a cable accessory device according to an embodiment of this application;
FIG. 8 is a schematic diagram of another cable accessory device and an equivalent circuit according to an embodiment of this application;
FIG. 9 is a schematic diagram of still another cable accessory device and an equivalent circuit according to an embodiment of this application;
FIG. 10 shows yet another cable accessory device according to an embodiment of this application;
FIG. 11 shows a novel looped fibre end seal according to an embodiment of this application;
FIG. 12 is a schematic diagram of a method for testing direct current resistance of a conductor structure without a repeater according to an embodiment of this application;
FIG. 13 is a schematic diagram of a method for testing direct current resistance of a conductor structure having a repeater according to an embodiment of this application;
FIG. 14 is a schematic diagram of a method for testing insulation resistance of an insulation structure without a repeater according to an embodiment of this application;
FIG. 15 is a schematic diagram of a method for testing insulation resistance of an insulation structure having a repeater according to an embodiment of this application;
FIG. 16 is a schematic diagram of an application scenario of a novel looped fibre end seal according to an embodiment of this application;
FIG. 17 is a schematic diagram of applications of a novel submarine cable terminal unit in a site equipment room according to an embodiment of this application;
FIG. 18 shows a novel submarine cable terminal unit according to an embodiment of this application; and
FIG. 19 shows a submarine cable accessory system according to an embodiment of this application.

### DETAILED DESCRIPTION OF THE EMBODIMENTS

An embodiment of this application provides a cable accessory device. By flexibly switching between a grounding mode and an open-circuit mode of a conductor structure in a cable, tests to direct current resistance of the conductor structure and insulation resistance of an insulation structure in the cable are facilitated, so that damages to the cable are found in time, and subsequent costs in locating and maintenance are reduced.

The terms such as "first", "second", "third", and "fourth" (if exist) in the specification, claims, and accompanying drawings of this application are used to distinguish similar objects, and are not necessarily used to describe a particular sequence or a sequential order. It should be understood that data used in this way can be interchanged in suitable cases, so that the embodiments described herein can be implemented in a sequence other than the content shown in the figures or described herein. In addition, the terms "including", "comprising", and any variants thereof are intended to cover a non-exclusive inclusion. For example, a process, a method, a system, a product, or a device that includes a series of steps or units is not limited to listed steps or units, but may further include a step or unit that is not clearly listed, or another inherent step or unit of the process, the method, the product, or the device.

In a current cable, usually a conductor structure and an insulation structure that wraps the conductor structure are disposed. The conductor structure may be a conductor structure that is in an electric cable and is configured to transmit power or signals, or may be a conductor structure that is in an optical cable and is configured to monitor the optical cable, or may be a conductor structure that is in the optical cable and is configured to supply power for a repeater. Performance of the conductor structure greatly affects performance of the cable. For example, if the conductor structure in the electric cable is fractured, a circuit is disconnected, and the power or signal cannot be transmitted. For another example, if the conductor structure in the optical cable is fractured, a light-guide fiber in the optical cable is probably damaged or fractured, thus transmission of optical information is affected. Performance of the insulation structure also greatly affects the performance of the cable. For example, if the insulation structure is damaged, the conductor structure is enabled to be connected to another external conductor, resulting in electric leakage.

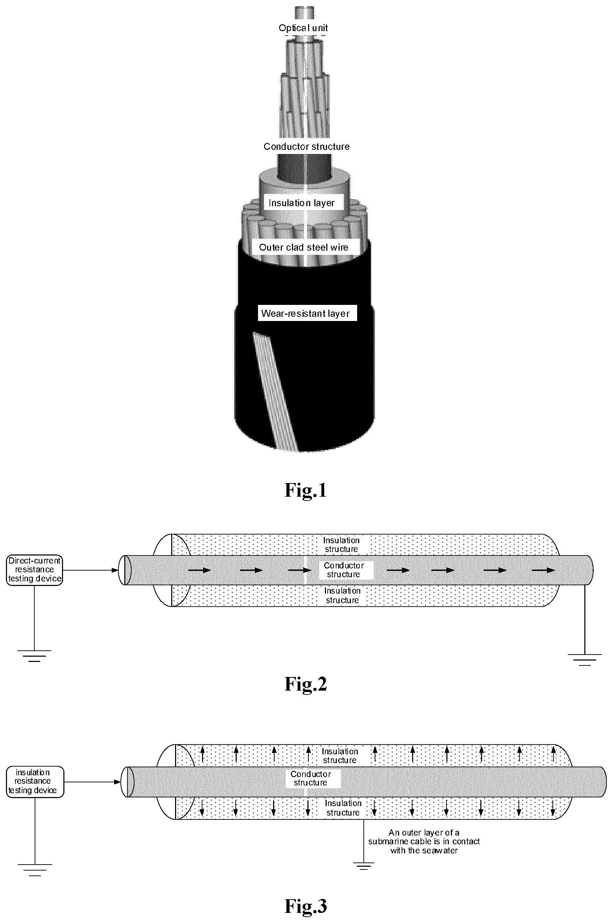

Using a submarine optical fiber cable (referred to as a submarine cable below for short), FIG. 1 shows a schematic structural diagram of a submarine cable. Structures from a center to outside of the submarine cable successively are an optical unit, a conductor structure, an insulation layer, outer clad steel wires, and a wear-resistant layer. The optical unit is a unit that is in direct contact with the light-guide fiber and protects the light-guide fiber, and may be a metal tube, a plastic tube, or a framework core. The conductor structure may be a composite conductor; for example, may be composed of a cooper tube and inner clad steel wires, and may be configured to transmit power or signals and may protect the optical unit at the same time. The insulation layer may insulate the conductor structure from other conductors, for example, may prevent seawater from being in contact with the conductor structure, so as to avoid electric leakage. The outer clad steel wires are configured to protect the insulation layer, the conductor structure, and the optical unit during transportation and mounting. The wear-resistant layer is configured to protect the outer clad steel wires and the internal insulation layer, conductor structure, and optical unit.

Conductivity of the conductor structure in the cable may be represented by using direct current resistance of the conductor structure. Specifically, if the direct current resistance of the conductor structure remarkably changes during a test process, it may be believed that the conductor structure is damaged or fractured, for example, the insulation structure that wraps the conductor structure is damaged or fractured. As a result, a middle portion of the conductor structure is exposed. The middle portion of the conductor structure is in contact with the seawater or the ground, and is in a grounding mode. In this case, a length of the conductor structure in a circuit is reduced, and it is correspondingly tested that the direct current resistance of the conductor structure is reduced. Refer to FIG. 2, which is a schematic diagram of a method for testing direct current resistance of a conductor structure according to an embodiment of this application. One end of the conductor structure in the cable may be applied with constant current by using a direct-current resistance testing device, and the other end of the conductor structure is connected to the ground, to form a current loop. A voltage value of the conductor structure is detected, and the direct current resistance of the conductor structure is calculated according to the Ohm's law.

Performance of the insulation structure in the cable may be represented by using insulation resistance of the insulation structure. Specifically, greater insulation resistance of the insulation structure indicates better insulativity, and smaller insulation resistance of the insulation structure indicates worse insulativity. It may be understood that if the calculated insulation resistance of the insulation structure is far smaller than a theoretical resistance value of the insulation structure, it may be considered that the insulation structure is damaged or fractured. The theoretical resistance value of the insulation structure is related to a material and a shape of the insulation structure. Refer to FIG. 3, and FIG. 3 is a schematic diagram of a method for testing insulation resistance of an insulation structure according to an embodiment of this application. One end of the conductor structure in the cable may be applied with constant voltage by using an insulation resistance testing device, and the other end of the conductor structure is set to be in an open-circuit state. Meanwhile, the insulation structure in the cable is connected to the ground. A current value in a current loop of the insulation structure is detected, and direct current resistance of the insulation structure, that is, the insulation resistance, is calculated according to the Ohm's law.

In a current test system, one end that is of the conductor structure and is far away from a power feeding equipment can merely be in one of a grounding state and an open-circuit state. In other words, one end that is of the conductor structure and is far away from the power feeding equipment is connected to the grounding electrode or is connected to an insulation medium. Using the submarine cable as an example, the seawater may serve as a conductor that is connected to the ground. One end that is of the conductor structure in the submarine cable and is far away from the power feeding equipment may be connected to the seawater, or the end that is of the conductor structure in the submarine cable and is far away from the power feeding equipment may be insulated from the seawater. To be specific, the direct current resistance of the conductor structure may be tested merely when the conductor structure is in the grounding state, or the insulation resistance of the insulation structure may be tested merely when the conductor structure is in the open-circuit state.

A current manner for implementing the grounding state or the open-circuit state of the end that is of the conductor structure in the cable and is far away from the power feeding equipment may be connecting a looped fibre end seal (LFES) to the end that is of the conductor structure and is far away from the power feeding equipment. There may be two types of LFESes. The grounding state or the open-circuit state of the end that is of the conductor structure and is far away from the power feeding equipment may be respectively implemented when the two types of LFESes are connected.

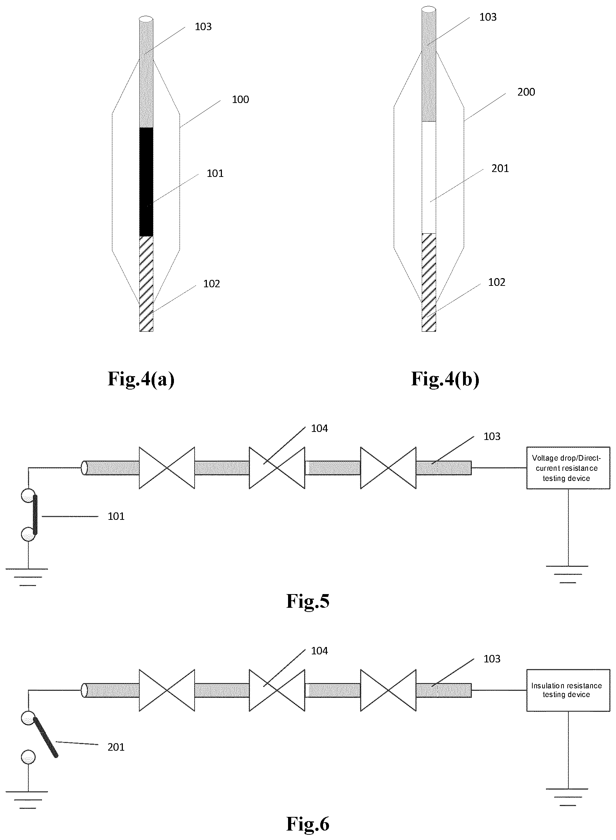

Specifically, refer to FIG. 4, and FIG. 4 is a schematic diagram of a looped fibre end seal in the prior art. FIG. 4 (a) shows a grounding mode LFES 100, including a conductor medium 101 and a grounding electrode 102 connected to one end of the conductor medium 101. The grounding electrode 102 is always connected to the ground or the seawater. The other end of the conductor medium 101 is connected to a conductor structure in a submarine cable 103. The conductor structure may be connected to the ground by using a conductor and the grounding electrode 102 that are connected thereto. Direct current resistance of the conductor structure in the submarine cable 103 is tested by using a LFES 100 in a grounding mode. Specifically, as shown in FIG. 5, a repeater 104 is disposed at middle of the submarine cable 103. The repeater 104 is configured to connect multiple sections of the submarine cable 103 between the looped fibre end seal and the power feeding equipment, and meanwhile amplify a signal in the submarine cable 103. The direct-current resistance testing device is connected to the conductor structure in the submarine cable 103, and the conductor structure in the submarine cable 103 is connected to the ground by using the conductor medium 101. Constant current is output to the conductor structure by using the direct-current resistance testing device, and corresponding voltage drop is detected, to calculate the direct current resistance of the conductor structure on this basis.

FIG. 4 (b) shows an LFES 200 in an open-circuit mode, including an insulation medium 201 and the grounding electrode 102 connected to one end of the insulation medium 201. The grounding electrode 102 is always connected to the ground or the seawater. The insulation medium 201 is connected to the conductor structure in the submarine cable 103. The insulation medium 201 breaks the connection between the conductor structure and the grounding electrode 102, to obtain an open-loop mode of the conductor structure. Insulation resistance of the insulation structure in the submarine cable 103 is tested by using the LFES 200 in the open-circuit mode. Specifically, as shown in FIG. 6, a repeater is disposed at the middle of the submarine cable 103. The insulation resistance testing device is connected to the conductor structure in the submarine cable 103. The insulation medium 201 prevents the conductor structure in the submarine cable 103 from being connected to the ground, to enable the conductor structure to be in an open-circuit mode. Constant voltage is applied to the conductor structure by using the insulation resistance testing device, and current in a return circuit is detected, to calculate the insulation resistance of the insulation structure in the submarine cable 103 on this basis.

In the test system, only the LFES 100 in the grounding mode or the LFES 200 in the open-circuit mode may be selected to be connected to the conductor structure in the submarine cable 103. Therefore, the direct current resistance of the conductor structure may be tested merely when the conductor structure is in the grounding state, or the insulation resistance of the insulation structure may be tested merely when the conductor structure is in the open-circuit state. However, the direct current resistance of the conductor structure is used to reflect the conductivity of the conductor structure, and the insulation resistance of the insulation structure is used to reflect insulativity of the insulation structure, where the two cannot be replaced by each other. Therefore, by merely testing the direct current resistance of the conductor structure or the insulation resistance of the insulation structure, failures of the cable cannot be comprehensively investigated. As a result, damages to the cable cannot be found in time, thus having a problem that subsequent costs in locating and maintenance are added.

To resolve the foregoing problem, embodiments of this application provide a cable accessory device and a submarine cable accessory system. The device includes a one-way conducting element and a grounding electrode. One end of the one-way conducting element is connected to a conductor structure in a cable, and the other end of the one-way conducting element is connected to the grounding electrode. The conductor structure in the cable is configured to enable, when being applied with voltage with different polarities, the one-way conducting element connected thereto to be applied with voltage with different polarities, so that the one-way conducting element has different on/off states. Specifically, when the on/off state of the one-way conducting element is an on state, the conductor structure in the cable is conducted to the grounding electrode, so as to detect direct current resistance of the conductor structure. Moreover, when the on/off state of the one-way conducting element is an off state, the connection between the conductor structure and the grounding electrode is broken, so as to test insulation resistance of an insulation structure. In other words, in the embodiments of this application, a grounding state and an open-circuit state of the conductor structure in the cable may be flexibly switched by changing the on/off state of the one-way conducting element. In this way, tests to the direct current resistance of the conductor structure and the insulation resistance of the insulation structure are facilitated in corresponding states of the conductor structure, so that failures of the cable may be comprehensively investigated to find damages to the cable in time, thus reducing subsequent costs in locating and maintenance.

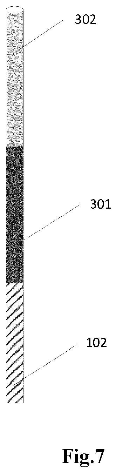

FIG. 7 shows a cable accessory device according to an embodiment of this application. The device may include a one-way conducting element 301 and a grounding electrode 102. The grounding electrode 102 may be a metal conductor or a conductor group in direct contact with the ground. When a cable 302 is a submarine cable, the grounding electrode 102 may be connected to the seawater; and when the cable 302 is a land cable, the grounding electrode 102 may be connected to the ground. Therefore, electric potential of the grounding electrode 102 is usually zero. One end of the one-way conducting element 301 is connected to a conductor structure in the cable 302, and the other end is connected to the grounding electrode 102.

The one-way conducting element 301 is an element that may have different on/off states. For example, when being applied with voltage with different polarities, the on/off state of the one-way conducting element 301 may be different. The one-way conducting element 301 may be a diode, such as a silicon diode or a germanium diode, or may be another element that may have different on/off states according to the applied voltage polarity. When the on/off state of the one-way conducting element 301 is an on state, the conductor structure in the cable 302 is conducted to the grounding electrode 102. When the on/off state of the one-way conducting element 301 is an off state, the connection between the conductor structure and the grounding electrode 102 is broken.

Specifically, a positive electrode of the one-way conducting element 301 may be connected to the grounding electrode 102, and a negative electrode may be connected to the conductor structure in the cable 302. If the conductor structure is applied with negative voltage, the negative electrode of the one-way conducting element 301 is applied with the negative voltage by using the conductor structure. In this case, due to characteristics of the one-way conducting element 301, resistance thereof is relatively small, and it may be considered that the one-way conducting element 301 is in the on state. The conductor structure in the cable 302 is conducted to the grounding electrode 102 by using the one-way conducting element 301. If the conductor structure is applied with positive voltage, the negative electrode of the one-way conducting element 301is applied with the positive voltage by using the conductor structure. In this case, due to characteristics of the one-way conducting element 301, resistance thereof is very large, and it may be considered that the one-way conducting element 301 is in the off state. The one-way conducting element 301 breaks the connection between the conductor structure and the grounding electrode 102.

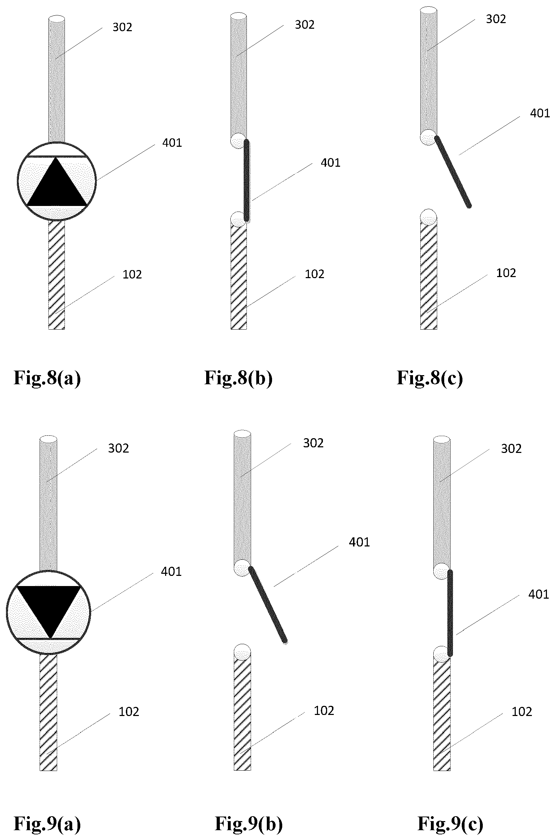

That a diode 401 serves as the one-way conducting element is used as an example. Refer to FIG. 8, and FIG. 8 is a schematic diagram of another cable accessory device and an equivalent circuit according to an embodiment of this application. FIG. 8 (a) shows another cable accessory device according to an embodiment of this application. A positive electrode of the diode 401 is connected to the grounding electrode 102, and a negative electrode is connected to the conductor structure in the cable 302. If the conductor structure is applied with negative voltage, and a voltage value of the negative voltage is greater than forward conduction voltage drop of the diode 401, the negative electrode of the diode 401 is applied with, by using the conductor structure, the negative voltage whose voltage value is greater than the forward conduction voltage drop of the diode 401. In this case, according to characteristics of the diode 401, the diode 401 has very small resistance, and may be considered to be in the on state. Refer to FIG. 8(b), and FIG. 8(b) is a schematic diagram of an equivalent circuit when the diode 401 is conducted. At this time, the conductor structure in the cable 302 is conducted to the grounding electrode102 by using the conducted diode 401. If the conductor structure is applied with positive voltage, the negative electrode of the diode 401 is applied with the positive voltage by using the conductor structure. In this case, according to characteristics of the diode, resistance thereof is very large, and it may be considered that the diode 401 is in the off state. Refer to FIG. 8(c), and FIG. 8(c) is schematic diagram of an equivalent circuit when the diode 401 is disconnected. At this time, the disconnected diode 401 breaks the connection between the conductor structure and the grounding electrode 102.

Specifically, the positive electrode of the one-way conducting element 301 may alternatively be connected to the conductor structure in the cable 302, and the negative electrode may be connected to the grounding electrode 102. If the conductor structure is applied with negative voltage, the positive electrode of the one-way conducting element 301 is applied with the negative voltage by using the conductor structure. In this case, due to characteristics of the one-way conducting element 301, resistance thereof is very large, and it may be considered that the one-way conducting element 301 is in the off state. The one-way conducting element 301 breaks the connection between the conductor structure and the grounding electrode 102. If the conductor structure is applied with positive voltage, the positive electrode of the one-way conducting element 301 is applied with the positive voltage by using the conductor structure. In this case, due to characteristics of the one-way conducting element 301, resistance thereof is very small, and it may be considered that the one-way conducting element 301 is in the on state. The conductor structure in the cable 302 is conducted to the grounding electrode 102 by using the one-way conducting element 301.

That the diode 401 serves as the one-way conducting element is used as an example. Refer to FIG. 9, and FIG. 9 is a schematic diagram of still another cable accessory device and an equivalent circuit according to an embodiment of this application. FIG. 9 (a) shows still another cable accessory device according to an embodiment of this application. The positive electrode of the diode 401 is connected to the conductor structure in the cable 302, and the negative electrode is connected to the grounding electrode 102. If the conductor structure is applied with negative voltage, the positive electrode of the diode 401 is applied with the negative voltage by using the conductor structure. In this case, according to the characteristics of the diode 401, the resistance thereof is very large, and it may be considered that the diode 401 is in the off state. Refer to FIG. 9(b), and FIG. 9(b) is a schematic diagram of an equivalent circuit when the diode 401 is disconnected. The disconnected diode 401 breaks the connection between the conductor structure and the grounding electrode 102. If the conductor structure is applied with positive voltage, and a voltage value of the positive voltage is greater than the forward conduction voltage drop of the diode 401, the positive electrode of the diode 401 is applied with, by using the conductor structure, the positive voltage whose voltage value is greater than the forward conduction voltage drop of the diode 401. In this case, according to the characteristics of the diode 401, the diode 401 has relatively small resistance, and may be considered to be in the on state. Refer to FIG. 9(c), and FIG. 9(c) is a schematic diagram of an equivalent circuit when the diode 401 is conducted. The conductor structure in the cable 302 is conducted to the grounding electrode102 by using the conducted diode 401.

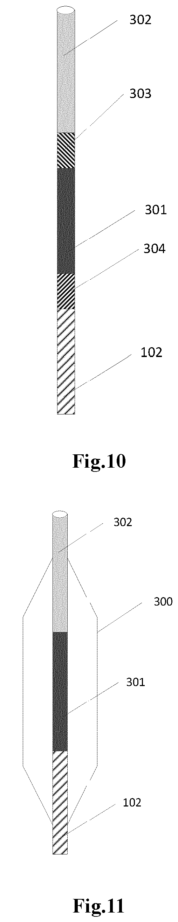

In the embodiments of this application, a first connection structure 303 may further be included between the one-way conducting element 301 and the conductor structure in the cable 302. Refer to FIG. 10, and FIG. 10 shows yet another cable accessory device according to an embodiment of this application. The first connection structure 303 may be made of a conductor material, and is configured to conduct the conductor structure in the cable 302 to the one-way conducting element 301. Similarly, a second connection structure 304 may further be included between the one-way conducting element 301 and the grounding electrode 102. As shown in FIG. 10, the second connection structure 304 may be made of a conductor material, and is configured to conduct the one-way conducting element 301 to the grounding electrode 102. The material of the second connection structure 304 may be same as or different from that of the first connection structure 303.

In an embodiment of this application, the one-way conducting element 301 and the grounding electrode 102 may further be packaged to form a novel LFES 300. FIG. 11 shows a novel LFES 300 according to an embodiment of this application, to protect the one-way conducting element 301, the grounding electrode 102, and the cable connected to the one-way conducting element. In this embodiment of this application, the one-way conducting element 301 and the grounding electrode 102 may further be packaged to form a novel submarine cable terminal unit (cable terminal unit, CTU) (not shown in the figure). The novel LFES 300 or the novel CTU may further include the first connection structure 303, to connect the one-way conducting element 301 and the conductor structure in the submarine cable 103; or may alternatively include the second connection structure 304, to connect the one-way conducting element 301 and the grounding electrode 102.

After the one-way conducting element 301 is connected to the conductor structure in the cable 302 and the one-way conducting element 301 is connected to the grounding electrode 102, different voltage may be applied to the conductor structure, to adjust the on/off state of the one-way conducting element 301, so as adjust the open-circuit state and the grounding state of the end that is of the conductor structure and is far away from the power feeding equipment. In this way, voltage drop, the direct current resistance of the conductor structure, and the insulation resistance of the insulation structure are tested in corresponding states.

Specifically, when the one-way conducting element 301 is in the on state, the resistance of the conductor structure may be detected by using the direct-current resistance testing device. The direct-current resistance testing device may include a power supply module, a voltage drop testing module, and a resistance calculation module. Constant current is output by using the power supply module. The voltage drop testing module tests voltage drop of a cable system. The resistance calculation module calculates the direct current resistance of the conductor structure according to the Ohm's law. During specific implementations, the direct-current resistance testing device may be connected to one end of the conductor structure in the cable 302. The other end of the conductor structure is connected to the grounding electrode 102 by using the one-way conducting element 301. Constant current is output by using the power supply module, so that the one-way conducting element 301 is conducted, and the direct-current resistance testing device, the conductor structure, the one-way conducting element 301, the grounding electrode 102, and the ground may form a current loop. The voltage drop of the cable system is detected by using the voltage drop testing module. The resistance calculation module calculates the direct current resistance of the conductor structure according to the Ohm's law based on the voltage drop and a value of the constant current output by the direct-current resistance testing device.

As stated above, using that the positive electrode of the one-way conducting element 301 is connected to the grounding electrode 102, and the negative electrode is connected to the conductor structure in the optical cable as an example, a direct-current resistance device may output negative current to the conductor structure. At this time, the one-way conducting element 301 is correspondingly in the on state. The conductor structure is conducted to the grounding electrode 102 by using the one-way conducting element 301. In other words, one end that is of the conductor structure and is connected to the one-way conducting element 301 is in the grounding mode.

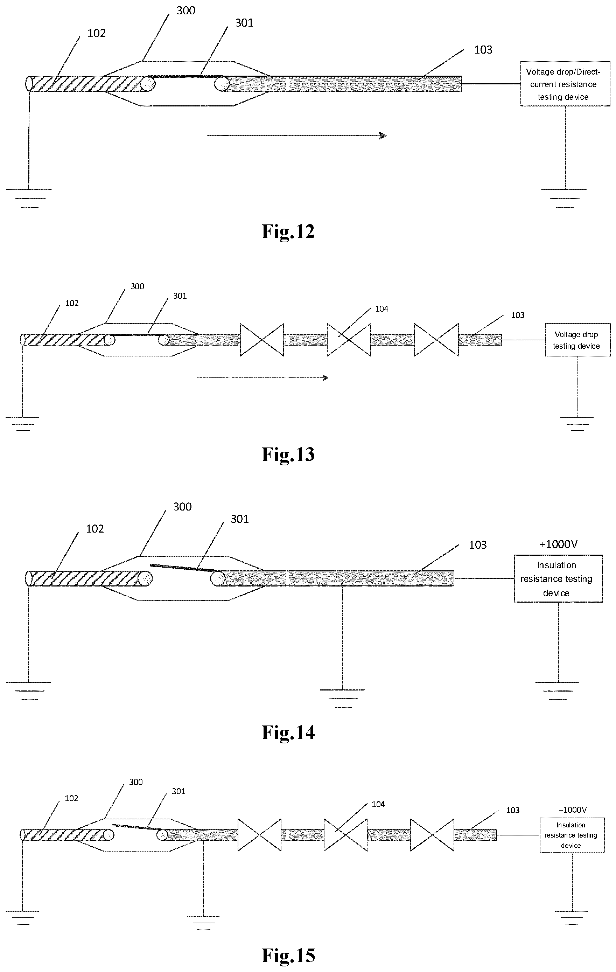

Using the submarine cable as an example, the test to the direct current resistance of the conductor structure may be initiated from a construction boat that is provided with a direct-current resistance testing device. When there is no repeater 104 between the construction boat and the cable accessory device, refer to FIG. 12, and FIG. 12 is a schematic diagram of a method for testing direct current resistance of a conductor structure without a repeater according to an embodiment of this application. Constant current output to the conductor structure by the direct-current resistance testing device may be -100 milliampere (mA). The direct-current resistance testing device, the conductor structure 103, the novel LFES 300, and the ground form a current loop. Entire voltage drop is tested by using the direct-current resistance testing device. In combination with a value of the constant current output by the direct-current resistance testing device, the direct current resistance of the conductor structure is calculated according to the Ohm's law. It should be noted that during a test process, because the one-way conducting element 301 has resistance when in the on state, calculating the direct current resistance of the conductor structure according to the Ohm's law specifically may be: calculating total resistance in a circuit based on the voltage drop detected by the direct-current resistance testing device and the current input by the direct-current resistance testing device; and subscribing equivalent resistance of the one-way conducting element 301 from the total resistance, to obtain the direct current resistance of the conductor structure. For example, during a test, maximum voltage of the used diode 401 is 2-4 volts (V), equivalent to that equivalent resistance of the diode 40 is 20-40 ohms (Ω). After the total resistance is calculated according to the Ohm's law, actual direct current resistance of the conductor structure may be obtained by subscribing the equivalent resistance of the diode 401 from the calculated total resistance.

After the direct current resistance of the conductor structure in the cable 302 is calculated, based on the obtained direct current resistance of the conductor structure, whether the conductor structure is damaged or fractured may be determined, and whether the insulation structure that wraps the conductor structure is damaged may be determined. Specifically, if the calculated direct current resistance is infinite, it may be considered that the conductor structure is fractured, and the insulation structure that wraps the conductor structure is intact. If a plurality of values of the calculated direct current resistance are remarkablydifferent from each other, usually it indicates that the direct current resistance of the conductor structure becomes smaller. In this case, it may be considered that the insulation structure that wraps the conductor structure is damaged. The reason is that the damaged insulation structure may expose the middle portion of the conductor structure. The middle portion of the conductor structure is in contact with the seawater or the ground, to be in the grounding mode, and the length of the conductor structure in the current loop is reduced. Therefore, the calculated direct current resistance of the conductor structure is reduced.

When determining that the insulation structure that wraps the conductor structure is damaged or fractured, a distance from one end that is of the conductor structure and is in contact with the direct-current resistance testing device to the exposed portion may further be calculated based on a value of the calculated direct current resistance of the conductor structure, so as to determine a position at which the insulation material is damaged. Specifically, a relationship between the direct current resistance and the length of the conductor structure may be obtained based on the material, a cross-sectional area, and other parameters of the conductor structure. For example, if resistance of a conductor structure with a length of 1 kilometer is 1 ohm, the calculated direct current resistance of the conductor structure is reduced by 30 ohms. This indicates that the insulation structure of the cable is damaged or fractured at a position from which a distance to a grounding end of the conductor structure is 30 kilometers.

Specifically, when the one-way conducting element 301 is in the on state, constant current may be output to the conductor structure by using the power feeding equipment (PFE). When the repeater 104 exists between the power feeding equipment and the cable accessory device, the constant current may enable the repeater 104 to work normally. For example, the constant current may be -1 A or -650 mA. The optical cable and the repeater 104 are optically monitored by using a coherent optical time domain reflectmeter (COTDR), and whether the optical cable is damaged is determined based on a received optical signal.

Specifically, when the one-way conducting element 301 is in the on state, the voltage drop of the conductor structure may be tested by using a voltage drop testing device. The voltage drop testing device may include a power supply module and a voltage drop testing module. During specific implementations, the voltage drop testing device may be configured to test voltage drop of the cable system. The cable system may include the conductor structure and the novel LFES 300, or the conductor structure and the novel CTU, or the conductor structure, the repeater 104, and the novel LFES 300, or the conductor structure, the repeater 104, and the novel CTU. The voltage drop testing device is connected to the conductor structure, to output constant current to the conductor structure. The power feeding equipment, the cable system, and the ground form a current loop. The constant current output by the power feeding equipment flows to the ground after passing through the repeater 104 and the cable accessory device provided in the embodiments of this application, or directly flows to the ground after passing through the cable accessory device provided in the embodiments of this application. The voltage drop testing device may test the voltage drop of the cable system.

After the voltage drop of the cable system is tested, a value of resistance of the cable system may be indicated by the voltage drop of the cable system. For example, under same constant current, greater voltage drop of the cable system indicates greater total resistance of the cable system. If the voltage drop of the cable system is smaller than or equal to preset voltage drop, the total resistance of the cable system is smaller than or equal to preset resistance, indicating that the cable system is damaged or fractured.

After the voltage drop of the cable system is tested, the direct current resistance of the conductor structure may also be calculated based on the voltage drop of the cable system. When there is no repeater between the voltage drop testing device and an accessory cable, for a calculation manner of the direct current resistance of the conductor structure, reference may be made to a calculation manner of the direct-current resistance testing device. When there is a repeater between the voltage drop testing device and the accessory cable, reference may be made to FIG. 13, and FIG. 13 is a schematic diagram of a method for testing direct current resistance of a conductor structure having a repeater according to an embodiment of this application. Constant current output by the voltage drop testing device to the conductor structure may enable the repeater 104 to work normally. The voltage drop testing device, the conductor structure 103, the repeater 104, the novel LFES 300, and the ground form a current loop. Entire voltage drop is tested by using the voltage drop testing device. In combination with a value of the constant current output by the voltage drop testing device, the direct current resistance of the conductor structure is calculated according to the Ohm's law. During the test process, in addition to the equivalent resistance of the one-way conducting element 301, equivalent resistance of the repeater 104 may also be considered. Specifically, the direct current resistance of the conductor structure may be calculated based on the entire voltage drop, the value of the constant current, the equivalent resistance of the one-way conducting element 301, and the resistance of the repeater 104. After the direct current resistance of the conductor structure is calculated, whether the conductor structure may be damaged or fractured may be further determined, and whether the insulation structure that wraps the conductor structure is damaged may be determined.

Specifically, when the one-way conducting element 301 is in the off state, the resistance of the insulation structure in the cable may be detected by using the insulation resistance testing device. The insulation resistance testing device may include the power feeding equipment and a current testing device. During specific implementations, the insulation resistance testing device may be connected to one end of the conductor structure, the other end of the conductor structure is in the open-circuit state, the insulation structure that wraps the conductor structure is connected to the conductor structure, and meanwhile, an outer side of the insulation structure is connected to the ground. Constant voltage is applied to the conductor structure by using the power feeding equipment. The power feeding equipment, the conductor structure, the insulation structure, and the ground form a current loop. Current in the current loop is detected by using the current testing device. The insulation resistance of the insulation structure is calculated according to the Ohm's law based on the constant voltage applied by the power feeding equipment and the current in the current loop.

As stated above, using that the positive electrode of the one-way conducting element 301 is connected to the grounding electrode 102, and the negative electrode is connected to the conductor structure in the optical cable as an example, the power feeding equipment may output positive voltage to the conductor structure, and the one-way conducting element 301 is correspondingly in the off state. The one-way conducting element 301 breaks the connection between the conductor structure and the grounding electrode 102. In other words, one end that is of the conductor structure and is connected to the one-way conducting element 301 is in the open-circuit mode.

For example, when there is no repeater 104 between a construction boat provided with an insulation resistance testing device and the cable accessory device, refer to FIG. 14, and FIG. 14 is a schematic diagram of a method for testing insulation resistance of an insulation structure without a repeater according to an embodiment of this application. Voltage output to the conductor structure by an isolation resistance testing device may be 500V or 1000V. The insulation resistance testing device, the conductor structure, the insulation structure, and the ground form a current loop. The insulation resistance of the insulation structure is calculated according to the Ohm's law based on the constant voltage applied by the power feeding equipment and current in the current loop. Correspondingly, the one-way conducting element 301 may support applications at 500V or 1000V. The one-way conducting element301 has very large resistance when in the off state. For example, the diode 401 is in the off state, and equivalent insulation resistance may be greater than 10 GΩ. Therefore, introduction of the one-way conducting element 301 would not affect a test result of the insulation resistance of the insulation structure.

When the repeater 104 exists between the construction boat provided with the insulation resistance testing device and the cable accessory device, refer to FIG. 15, and FIG. 15 is a schematic diagram of a method for testing insulation resistance of an insulation structure having a repeater according to an embodiment of this application. The voltage output to the conductor structure by the isolation testing device may be 1000V. The insulation resistance testing device, the conductor structure, the repeater 104, the insulation structure, and the ground form a current loop. The insulation resistance of the insulation structure is calculated according to the Ohm's law based on the constant voltage applied by the power feeding equipment and current in the current loop. In addition, both the direct current resistance of the conductor structure and the resistance of the repeater are far smaller than the insulation resistance of the insulation structure, and may be ignored. Therefore, a resistance value calculated according to the Ohm's law may serve as the insulation resistance of the insulation structure.

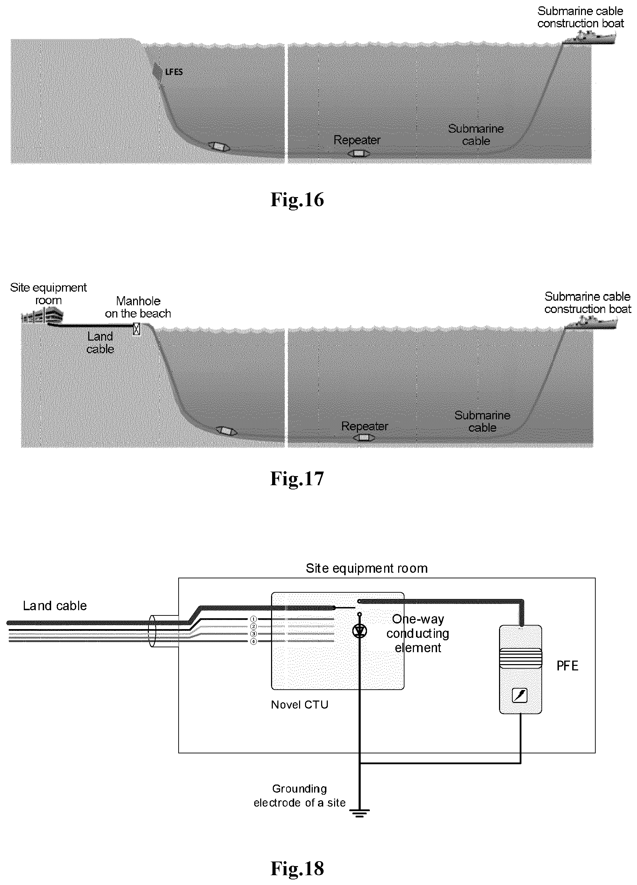

In actual operations, the novel LFES 300 provided in the embodiments of this application may be disposed under the ground or the seabed. Refer to FIG. 16, and FIG. 16 shows a schematic diagram of an application scenario of a novel LFES according to an embodiment of this application. Specifically, the novel LFES 300 is disposed at the seabed. By disposing the power feeding equipment on the submarine cable construction boat, the on/off state of the one-way conducting element 301 is adjusted by applying voltage with different polarities to the one-way conducting element 301, to conduct the conductor structure to the seawater and isolate the conductor structure from the seawater. In other words, the grounding mode and the open-circuit mode of the conductor structure are switched.

In actual operations, the novel CTU provided in the embodiments of this application may be disposed in a site equipment room. Refer to FIG. 16, and FIG. 16 shows a schematic diagram of applications of a novel CTU in a site equipment room according to an embodiment of this application. Specifically, in a manhole on the beach, one end of the submarine cable is connected to a land cable, and the land cable is connected to the novel CTU in the site equipment room. After providing the power feeding equipment on the submarine cable construction boat, the power feeding equipment is connected to the other end of the submarine cable. The on/off state of the one-way conducting element 301 is adjusted by applying voltages with different polarities to the one-way conducting element 301 via the conductor structure in the submarine cable, thus switching between the grounding mode and the open-circuit mode of the conductor structure.

A switch may further be disposed in the novel CTU. Refer to FIG. 17, and FIG. 17 shows a novel CTU according to an embodiment of this application. The switch may include a stationary contact and a movable contact. The stationary contact may be connected to the conductor structure. When the conductor structure is in a test mode, the movable contact may be connected to the one-way conducting element 301, to switch between the grounding mode and the open-circuit mode of the conductor structure, so as to test the voltage drop or the direct current resistance of the conductor structure, or test the insulation resistance of the insulation structure. When the conductor structure is in an operation mode, the movable contact may be connected to the power feeding equipment in the site equipment room, so that the power feeding equipment supplies power for the conductor structure by using the switch, thus saving labor costs and time costs required for mode switching. Specific types of the switch are not defined in the embodiments of this application. A person skilled in the art may select according to actual application scenarios and a voltage level. For example, the switch type may be any one of the following: a metal-oxide semiconductor (MOS) field-effect transistor, an insulated gate bipolar transistor (IGBT), a bipolar junction transistor (BJT), or a relay.

An embodiment of this application provides a cable accessory device. The device includes a one-way conducting element and a grounding electrode. One end of the one-way conducting element is connected to a conductor structure in a cable, and the other end of the one-way conducting element is connected to the grounding electrode. When the one-way conducting element is applied with voltage with different polarities, the one-way conducting element has different on/off states. Specifically, when the on/off state of the one-way conducting element is an on state, the conductor structure in the cable is connected to the grounding electrode via the one-way conducting element, so as to measure direct current resistance of the conductor structure. Moreover, when the on/off state of the one-way conducting element is an off state, the one-way conducting element may enable the connection between the conductor structure and the grounding electrode, so as to measure insulation resistance of an insulation structure. In other words, in this embodiment of this application, a grounding state and an open-circuit state of the conductor structure in the cable may be flexibly switched by changing the on/off state of the one-way conducting element. In this way, measurement of the direct current resistance of the conductor structure and the insulation resistance of the insulation structure are facilitated in corresponding states of the conductor structure, so that failures of the cable may be comprehensively investigated and damages to the cable may be found in time.

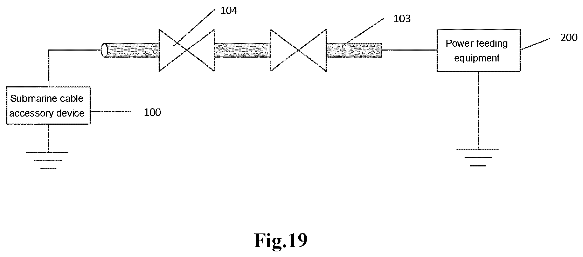

On the basis of the foregoing cable accessory device, an embodiment of this application further provides a submarine cable accessory system. Refer to IG. 19, and FIG. 19 shows a submarine cable accessory system according to an embodiment of this application. The submarine cable accessory system includes a submarine cable accessory device 100, a power feeding equipment 200, and a repeater 104. The repeater 104 is connected between the submarine cable accessory device 100 and the power feeding equipment 200 by using a submarine cable 103.

The submarine cable accessory device 100 includes a one-way conducting element and a grounding electrode. One end of the one-way conducting element is connected to a conductor structure in the submarine cable 103, and the other end of the one-way conducting element is connected to the grounding electrode.

The grounding electrode may be a metal conductor or a conductor group in direct contact with the ground. When the cable is a submarine cable, the grounding electrode may be connected to the seawater. Electric potential of the grounding electrode is usually zero.

The conductor structure in the submarine cable 103 is configured to enable, when a power feeding equipment 200 is applied with voltage with different polarities, the one-way conducting element to be applied with voltage with different polarities, so as to have different on/off states. The conductor structure may be a composite conductor; for example, may be composed of a cooper tube and an inner clad steel wire; and may be configured to transmit power or a signal and may protect an optical unit at the same time.

The one-way conducting element is an element that may have different on/off states. For example, when being applied with voltage with different polarities, the on/off state of the one-way conducting element may be different. The one-way conducting element may be a diode, such as a silicon diode or a germanium diode, or may be another element that may have different on/off states according to the applied voltage polarity. When the on/off state of the one-way conducting element is an on state, the conductor structure in the cable is conducted to the grounding electrode. When the on/off state of the one-way conducting element is an off state, the connection between the conductor structure and the grounding electrode is broken.

The repeater 104 is configured to connect multiple sections of the submarine cable 103 between the submarine cable accessory device 100 and the power feeding equipment 200, and amplify a signal in the submarine cable 103, for example, amplify an optical signal in the submarine cable 103, to optically monitor the submarine cable 103.

In this embodiment of this application, the one-way conducting element and the grounding electrode may further be packaged, to form a novel LFES to serve as the submarine cable accessory device 100, to protect the one-way conducting element, the grounding electrode, and the cable connected to the one-way conducting element. In this embodiment of this application, the one-way conducting element and the grounding electrode may further be packaged, to form a novel submarine cable terminal unit to serve as the submarine cable accessory device 100.

According to the submarine cable accessory system provided in this embodiment of this application, the grounding state and the open-circuit state of the conductor structure in the cable may be flexibly switched by changing the on/off state of the one-way conducting element. In this way, tests to the direct current resistance of the conductor structure and the insulation resistance of the insulation structure are facilitated in corresponding states of the conductor structure, so that failures of the cable may be comprehensively investigated to find damages to the cable in time.

A person skilled in the art may clearly understand that for easy and simplicity of description, for specific working processes of the system, device, and unit that are described above, reference may be made to corresponding processes in the foregoing method embodiments, and details are not described herein again.

In the embodiments provided in this application, it should be understood that the disclosed system, device, and method may be implemented in other manners. For example, the device embodiments described above are merely exemplary. For example, the division of units is only a division of logical functions. In actual implementations, there may be other division manners. For example, a plurality of units or components may be combined or integrated into another system, or some features may be ignored or not implemented. In addition, the displayed or discussed mutual coupling or direct coupling or communications connection may be indirect coupling or communication connections through some interfaces, devices or units, and may be in electrical, mechanical, or other forms.

Units described as separated parts may be or may not be physically separated; and parts displayed as units may be or may not be physical unit, that is, may be located at one place or may be distributed on a plurality of network units. Some or all of the units may be selected according to actual requirements to achieve the objectives of the solutions of the embodiments.

In addition, all functional units in the embodiments of this application may be integrated into one processing unit, or each unit may exist alone physically, or two or more units may be integrated into one unit. The foregoing integrated unit may be implemented in a form of hardware, or may be implemented in a form of a software function unit.

If the integrated unit is implemented in the form of a software functional unit and is sold or used as an independent product, the integrated unit may be stored in a computer-readable storage medium. On the basis of such understanding, the technical solutions of this application essentially, or parts of the technical solutions of this application that attribute to the prior art, or all or part of the technical solutions may be represented in the form of software products. A computer software product may be stored in a storage medium, and includes a plurality of instructions to enable a computer device (which may be a personal computer, a server, a network device, or the like) to implement all or some steps of the method in all embodiments of this application. The foregoing storage media include various media that can store program codes, such as a U disk, mobile hard disk, a read-only memory (ROM), a random access memory (RAM), a magnetic disk, or an optical disk.

## Claims

1. A cable accessory device, wherein the device comprises: a one-way conducting element (301) and a grounding electrode (102), one end of the one-way conducting element being connected to a conductor structure in the cable, and the other end of the one-way conducting element being connected to the grounding electrode;
the conductor structure in the cable is configured to enable, when being applied with voltages with different polarities, the one-way conducting element to have different on/off states; and
the one-way conducting element is configured to connect the conductor structure in the cable to the grounding electrode when the on/off state is an on state, and to break connection between the conductor structure and the grounding electrode when the on/off state is an off state,
**characterized in that** a positive electrode of the one-way conducting element is connected to the conductor structure, and a negative electrode is connected to the grounding electrode; and
wherein the conductor structure in the cable being configured to enable, when being applied with voltage with different polarities, the one-way conducting element to have different on/off states, comprises:
enabling the one-way conducting element to be in the off state when the conductor structure is applied with negative voltage; and
enabling the one-way conducting element to be in the on state when the conductor structure is applied with positive voltage.

2. The cable accessory device according to claim 1, wherein a positive electrode of the one-way conducting element is connected to the grounding electrode, and a negative electrode of the one-way conducting element is connected to the conductor structure; and
wherein the conductor structure in the cable being configured to enable, when being applied with voltages with different polarities, the one-way conducting element to have different on/off states, comprises:
enabling the one-way conducting element to be in the on state when the conductor structure is applied with negative voltage; and
enabling the one-way conducting element to be in the off state when the conductor structure is applied with positive voltage.

3. The cable accessory device according to any one of claims 1 or 2, further comprising a first connection structure that is connected between the conductor structure in the cable and the one-way conducting element, and is configured to connect the conductor structure in the cable with the one-way conducting element.

4. The cable accessory device according to any one of claims 1 to 5, further comprising a second connection structure that is connected between the one-way conducting element and the grounding electrode, and is configured to connect the one-way conducting element with the grounding electrode.

5. The cable accessory device according to any one of claims 1 to 4, further comprising:
a direct-current resistance testing device, configured to measure direct current resistance of the conductor structure when the one-way conducting element is in the on state.

6. The cable accessory device according to any one of claims 1 to 5, further comprising:
an insulation resistance testing device, configured to measure insulation resistance of an insulation structure in the cable when the one-way conducting element is in the off state.

7. The cable accessory device according to any one of claims 1 to 6, wherein the one-way conducting element comprises a diode.

8. The cable accessory device according to any one of claims 1 to 7, wherein the cable accessory device comprises a switch, the switch comprises a stationary contact and a movable contact, and the stationary contact is connected to the conductor structure;
when the conductor structure is in a test mode, the movable contact is connected to the one-way conducting element; and
when the conductor structure is in an operation mode, the movable contact is connected to a power feeding equipment.

9. The cable accessory device according to claim 8, wherein the cable accessory device comprises a submarine cable terminal unit.

10. The cable accessory device according to any one of claims 1 to 9, wherein the cable accessory device comprises a looped fibre end seal.

11. A submarine cable accessory system, comprising a submarine cable accessory device (100), a power feeding equipment (200), and a repeater (104), wherein
the repeater is connected between the submarine cable (103) accessory device and the power feeding equipment via a submarine cable, wherein
the submarine cable accessory device comprises: a one-way conducting element (100) and a grounding electrode, one end of the one-way conducting element being connected to a conductor structure in the submarine cable, and the other end of the one-way conducting element being connected to the grounding electrode;
the conductor structure in the submarine cable is configured to enable, when being applied with voltages with different polarities by the power feeding equipment, the one-way conducting element to have different on/off states;
the one-way conducting element is configured to connect the conductor structure in the submarine cable to the grounding electrode when the on/off state is an on state, and to break connection between the conductor structure and the grounding electrode when the on/off state is an off state;
a positive electrode of the one-way conducting element is connected to the conductor structure, and a negative electrode is connected to the grounding electrode; and
wherein the conductor structure in the submarine cable being configured to enable, when being applied with voltage with different polarities, the one-way conducting element to have different on/off states, comprises:
enabling the one-way conducting element to be in the off state when the conductor structure is applied with negative voltage; and
enabling the one-way conducting element to be in the on state when the conductor structure is applied with positive voltage; and
the repeater is configured to connect multiple sections of the submarine cable between the submarine cable accessory device and the power feeding equipment, and amplify a signal in the submarine cable.

12. The system according to claim 11, wherein the submarine cable accessory device comprises a submarine cable terminal unit.

13. The system according to claim 11, wherein the submarine cable accessory device comprises a looped fibre end seal.

14. The system according to claim 11, wherein the conductor structure in the submarine cable is a composite conductor.

## Patentansprüche

1. Kabelzubehörvorrichtung, wobei die Vorrichtung Folgendes umfasst: ein unidirektionales Leitungselement (301) und eine Erdungselektrode (102), wobei ein Ende des unidirektionalen Leitungselements mit einer Leiterstruktur im Kabel verbunden ist und das andere Ende des unidirektionalen Leitungselements mit der Erdungselektrode verbunden ist;
wobei die Leiterstruktur im Kabel konfiguriert ist, um zu ermöglichen, wenn Spannungen mit verschiedenen Polaritäten angelegt werden, dass das unidirektionale Leitungselement verschiedene Ein-/Aus-Zustände aufweist; und
das unidirektionale Leitungselement konfiguriert ist, die Leiterstruktur im Kabel mit der Erdungselektrode zu verbinden, wenn der Ein/Aus-Zustand ein Ein-Zustand ist, und die Verbindung zwischen der Leiterstruktur und der Erdungselektrode zu unterrechen, wenn der Ein/Aus-Zustand ein Aus-Zustand ist,
**dadurch gekennzeichnet, dass** eine positive Elektrode des unidirektionalen Leitungselements mit der Leiterstruktur verbunden ist und eine negative Elektrode mit der Erdungselektrode verbunden ist;
wobei die Leiterstruktur im Kabel, die konfiguriert ist, um zu ermöglichen, wenn Spannung mit verschiedenen Polaritäten angelegt wird, dass das unidirektionale Leitungselement verschiedene Ein-/Aus-Zustände aufweist, Folgendes umfasst:
Ermöglichen, dass das unidirektionale Leitungselement im Aus-Zustand ist, wenn auf die Leiterstruktur eine negative Spannung angelegt wird; und
Ermöglichen, dass das unidirektionale Leitungselement im Ein-Zustand ist, wenn auf die Leiterstruktur eine positive Spannung angelegt wird.

2. Kabelzubehörvorrichtung nach Anspruch 1, wobei eine positive Elektrode des unidirektionalen Leitungselements mit der Erdungselektrode verbunden ist, und eine negative Elektrode des unidirektionalen Leitungselements mit der Leiterstruktur verbunden ist; und
wobei die Leiterstruktur im Kabel, die konfiguriert ist, um zu ermöglichen, wenn Spannungen mit verschiedenen Polaritäten angelegt werden, dass das unidirektionale Leitungselement verschiedene Ein-/Aus-Zustände aufweist, Folgendes umfasst:
Ermöglichen, dass das unidirektionale Leitungselement im Ein-Zustand ist, wenn auf die Leiterstruktur eine negative Spannung angelegt wird; und
Ermöglichen, dass das unidirektionale Leitungselement im Aus-Zustand ist, wenn auf die Leiterstruktur eine positive Spannung angelegt wird.

3. Kabelzubehörvorrichtung nach einem der Ansprüche 1 oder 2, weiter umfassend eine erste Verbindungsstruktur, die zwischen der Leiterstruktur im Kabel und dem unidirektionalen Leitungselement verbunden ist, und konfiguriert, um die Leiterstruktur im Kabel mit dem unidirektionalen Leitungselement zu verbinden.

4. Kabelzubehörvorrichtung nach einem der Ansprüche 1 bis 5, weiter umfassend eine zweite Verbindungsstruktur, die zwischen dem unidirektionalen Leitungselement und der Erdungselektrode verbunden ist und konfiguriert, um das unidirektionale Leitungselement mit der Erdungselektrode zu verbinden.

5. Kabelzubehörvorrichtung nach einem der Ansprüche 1 bis 4, weiter umfassend:
eine Gleichstrom-Widerstandstestvorrichtung, die konfiguriert ist, um den Gleichstromwiderstand der Leiterstruktur zu messen, wenn sich das unidirektionale Leitungselement im Ein-Zustand befindet.

6. Kabelzubehörvorrichtung nach einem der Ansprüche 1 bis 5, weiter umfassend:
eine Isolationswiderstandstestvorrichtung, die konfiguriert ist, um den Isolationswiderstand einer Isolationsstruktur im Kabel zu messen, wenn sich das unidirektionale Leitungselement im Aus-Zustand befindet.

7. Kabelzubehörvorrichtung nach einem der Ansprüche 1 bis 6, wobei das unidirektionale Leitungselement eine Diode umfasst.

8. Kabelzubehörvorrichtung nach einem der Ansprüche 1 bis 7, wobei die Kabelzubehörvorrichtung einen Schalter umfasst, der Schalter einen stationären Kontakt und einen beweglichen Kontakt umfasst und der stationäre Kontakt mit der Leiterstruktur verbunden ist;
wenn sich die Leiterstruktur in einem Testmodus befindet, der bewegliche Kontakt mit dem unidirektionalen Leitungselement verbunden ist; und
wenn sich die Leiterstruktur in einem Betriebsmodus befindet, der bewegliche Kontakt mit einer Stromversorgungseinrichtung verbunden ist.

9. Kabelzubehörvorrichtung nach Anspruch 8, wobei die Kabelzubehörvorrichtung eine Unterseekabel-Anschlusseinheit umfasst.

10. Kabelzubehörvorrichtung nach einem der Ansprüche 1 bis 9, wobei die Kabelzubehörvorrichtung eine geschlungene Faserenddichtung aufweist.

11. Unterseekabel-Zubehörsystem, umfassend eine Unterseekabel-Zubehörvorrichtung (100), eine Stromversorgungseinheit (200) und einen Repeater (104), wobei
der Repeater zwischen der Unterseekabel (103)-Zubehörvorrichtung und der Stromversorgungseinheit über ein Unterseekabel verbunden ist, wobei
die Unterseekabel-Zubehörvorrichtung Folgendes umfasst: ein unidirektionales Leitungselement (100) und eine Erdungselektrode, wobei ein Ende des unidirektionalen Leitungselements mit einer Leiterstruktur im Unterseekabel und das andere Ende des unidirektionalen Leitungselements mit der Erdungselektrode verbunden ist;
wobei die Leiterstruktur im Unterseekabel konfiguriert ist, um zu ermöglichen, wenn von der Stromversorgungseinheit Spannungen mit verschiedenen Polaritäten angelegt werden, dass das unidirektionale Leitungselement verschiedene Ein-/Aus-Zustände aufweist;
das unidirektionale Leitungselement konfiguriert ist, um die Leiterstruktur im Unterseekabel mit der Erdungselektrode zu verbinden, wenn der Ein/Aus-Zustand ein Ein-Zustand ist, und die Verbindung zwischen der Leiterstruktur und der Erdungselektrode zu unterbrechen, wenn der Ein/Aus-Zustand ein Aus-Zustand ist,
eine positive Elektrode des unidirektionalen Leitungselements mit der Leiterstruktur verbunden ist, und eine negative Elektrode mit der Erdungselektrode verbunden ist; und
wobei die Leiterstruktur des Unterseekabels, die konfiguriert ist, um zu ermöglichen, wenn Spannungen mit verschiedenen Polaritäten angelegt werden, dass das unidirektionale Leitungselement verschiedene Ein-/Aus-Zustände aufweist, Folgendes umfasst:
Ermöglichen, dass das unidirektionale Leitungselement im Aus-Zustand ist, wenn auf die Leiterstruktur eine negative Spannung angelegt wird; und
Ermöglichen, dass das unidirektionale Leitungselement im Ein-Zustand ist, wenn auf die Leiterstruktur eine positive Spannung angelegt wird; und
der Repeater konfiguriert ist, um zahlreiche Abschnitte des Unterseekabels zwischen der Unterseekabelzubehörvorrichtung und der Stromversorgungseinheit zu verbinden, um ein Signal im Unterseekabel zu verstärken.

12. System nach Anspruch 11, wobei die Unterseekabelzubehörvorrichtung eine Unterseekabelanschlusseinheit umfasst.

13. System nach Anspruch 11, wobei die Unterseekabelzubehörvorrichtung ein geschlungene Faserenddichtung umfasst.

14. System nach Anspruch 11, wobei die Leiterstruktur im Unterseekabel ein Verbundleiter ist.

## Revendications

1. Dispositif d'accessoire de câble, dans lequel le dispositif comprend : un élément à conduction unilatérale (301) et une électrode de mise à la terre (102), une extrémité de l'élément à conduction unilatérale étant connectée à une structure de conducteur dans le câble, et l'autre extrémité de l'élément à conduction unilatérale étant connectée à l'électrode de mise à la terre ;
la structure de conducteur dans le câble est configurée pour permettre, lorsque des tensions qui présentent différentes polarités y sont appliquées, à l'élément à conduction unilatérale d'avoir différents états d'activation/de désactivation ; et
l'élément à conduction unilatérale est configuré pour connecter la structure de conducteur dans le câble à l'électrode de mise à la terre lorsque l'état d'activation/de désactivation est un état d'activation, et pour rompre la connexion entre la structure de conducteur et l'électrode de mise à la terre lorsque l'état d'activation/de désactivation est un état de désactivation,
**caractérisé en ce qu'**une électrode positive de l'élément à conduction unilatérale est connectée à la structure de conducteur, et une électrode négative est connectée à l'électrode de mise à la terre ; et
dans lequel la structure de conducteur dans le câble configurée pour permettre, lorsque des tensions qui présentent différentes polarités y sont appliquées, à l'élément à conduction unilatérale d'avoir différents états d'activation/de désactivation, comprend :
le fait de permettre à l'élément à conduction unilatérale d'être dans l'état de désactivation lorsqu'une tension négative est appliquée à la structure de conducteur ; et
le fait de permettre à l'élément à conduction unilatérale d'être dans l'état d'activation lorsqu'une tension positive est appliquée à la structure de conducteur.

2. Dispositif d'accessoire de câble selon la revendication 1, dans lequel une électrode positive de l'élément à conduction unilatérale est connectée à l'électrode de mise à la terre, et une électrode négative de l'élément à conduction unilatérale est connectée à la structure de conducteur ; et
dans lequel la structure de conducteur dans le câble configurée pour permettre, lorsque des tensions de différentes polarités y sont appliquées, à l'élément à conduction unilatérale d'avoir différents états d'activation/de désactivation, comprend :
le fait de permettre à l'élément à conduction unilatérale d'être dans l'état d'activation lorsqu'une tension négative est appliquée à la structure de conducteur ; et
le fait de permettre à l'élément à conduction unilatérale d'être dans l'état de désactivation lorsqu'une tension positive est appliquée à la structure de conducteur.

3. Dispositif d'accessoire de câble selon l'une quelconque des revendications 1 ou 2, comprenant en outre une première structure de connexion qui est connectée entre la structure de conducteur dans le câble et l'élément à conduction unilatérale, et est configurée pour connecter la structure de conducteur dans le câble à l'élément à conduction unilatérale.

4. Dispositif d'accessoire de câble selon l'une quelconque des revendications 1 à 5, comprenant en outre une deuxième structure de connexion qui est connectée entre l'élément à conduction unilatérale et l'électrode de mise à la terre, et est configurée pour connecter l'élément à conduction unilatérale à l'électrode de mise à la terre.

5. Dispositif d'accessoire de câble selon l'une quelconque des revendications 1 à 4, comprenant en outre :
un dispositif de test de résistance au courant continu, configuré pour mesurer la résistance au courant continu de la structure de conducteur lorsque l'élément à conduction unilatérale se trouve dans l'état d'activation.

6. Dispositif d'accessoire de câble selon l'une quelconque des revendications 1 à 5, comprenant en outre :
un dispositif de test de résistance d'isolement, configuré pour mesurer la résistance d'isolement d'une structure d'isolement dans le câble lorsque l'élément à conduction unilatérale se trouve dans l'état de désactivation.

7. Dispositif d'accessoire de câble selon l'une quelconque des revendications 1 à 6, dans lequel l'élément à conduction unilatérale comprend une diode.

8. Dispositif d'accessoire de câble selon l'une quelconque de revendications 1 à 7, dans lequel le dispositif d'accessoire de câble comprend un commutateur, le commutateur comprend un contact stationnaire et un contact mobile, et le contact stationnaire est connecté à la structure de conducteur ;
lorsque la structure de conducteur se trouve dans un mode de test, le contact mobile est connecté à l'élément à conduction unilatérale ; et
lorsque la structure de conducteur se trouve dans un mode de fonctionnement, le contact mobile est connecté à un équipement d'alimentation électrique.

9. Dispositif d'accessoire de câble selon la revendication 8, dans lequel le dispositif d'accessoire de câble comprend une unité de tête de câble sous-marin.

10. Dispositif d'accessoire de câble selon l'une quelconque des revendications 1 à 9, dans lequel le dispositif d'accessoire de câble comprend un embout protecteur de fibre sous forme de boucle.

11. Système d'accessoire de câble sous-marin, comprenant un dispositif d'accessoire de câble sous-marin (100), un équipement d'alimentation électrique (200), et un répétiteur (104), dans lequel le répétiteur est connecté entre le dispositif d'accessoire de câble sous-marin (103) et l'équipement d'alimentation électrique via un câble sous-marin, dans lequel
le dispositif d'accessoire de câble sous-marin comprend : un élément à conduction unilatérale (100) et une électrode de mise à la terre, une extrémité de l'élément à conduction unilatérale étant connectée à une structure de conducteur dans le câble sous-marin, et l'autre extrémité de l'élément à conduction unilatérale étant connectée à l'électrode de mise à la terre ;
la structure de conducteur dans le câble sous-marin est configurée pour permettre, lorsque des tensions de différentes polarités y sont appliquées par l'équipement d'alimentation électrique, à l'élément à conduction unilatérale d'avoir différents états d'activation/de désactivation ;
l'élément à conduction unilatérale est configuré pour connecter la structure de conducteur dans le câble sous-marin à l'électrode de mise à la terre lorsque l'état d'activation/de désactivation est un état d'activation, et pour rompre la connexion entre la structure de conducteur et l'électrode de mise à la terre lorsque l'état d'activation/de désactivation est un état de désactivation ;
une électrode positive de l'élément à conduction unilatérale est connectée à la structure de conducteur, et une électrode négative et connectée à l'électrode de mise à la terre ; et
dans lequel la structure de conducteur dans le câble sous-marin configurée pour permettre, lorsque des tensions de différentes polarités y sont appliquées, à l'élément à conduction unilatérale d'avoir différents états d'activation/de désactivation, comprend :
le fait de permettre à l'élément à conduction unilatérale d'être dans l'état de désactivation lorsqu'une tension négative est appliquée à la structure de conducteur ; et
le fait de permettre à l'élément à conduction unilatérale d'être dans l'état d'activation lorsqu'une tension positive est appliquée à la structure de conducteur ; et
le répétiteur est configuré pour connecter plusieurs sections du câble sous-marin entre le dispositif d'accessoire de câble sous-marin et l'équipement d'alimentation électrique, et amplifier un signal dans le câble sous-marin.

12. Système selon la revendication 11, dans lequel le dispositif d'accessoire de câble sous-marin comprend une unité de tête de câble sous-marin.

13. Système selon la revendication 11, dans lequel le dispositif d'accessoire de câble sous-marin comprend un embout protecteur de fibre sous forme de boucle.

14. Système selon la revendication 11, dans lequel la structure de conducteur dans le câble sous-marin est un conducteur composite.
